(19) Europäisches Patentamt

European Patent Office

Office européen des brevets

(11) **EP 1 686 620 A1**

(12) **EUROPEAN PATENT APPLICATION**

(43) Date of publication:
02.08.2006 Bulletin 2006/31

(51) Int Cl.:
*H01L 21/768* (2006.01)   *H01L 21/8247* (2006.01)
*H01L 27/115* (2006.01)

(21) Application number: 05425034.5

(22) Date of filing: 28.01.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(71) Applicant: STMicroelectronics S.r.l.
20041 Agrate Brianza (Milano) (IT)

(72) Inventors:
• Brazzelli, Daniela
  21052 Busto Arsizio (IT)

• Servalli, Giorgio
  24040 Ciserano (IT)
• Erbetta, Davide
  24047 Treviglio (IT)
• Marangon, Maria Santina
  23807 Merate (IT)

(74) Representative: Cerbaro, Elena et al
c/o Studio Torta S.r.l. Via Viotti, 9
10121 Torino (IT)

(54) **Process for manufacturing a memory with local electrical contact between the source line and the well**

(57)   In a process for manufacturing a memory (2) having a plurality of memory cells (3) the steps of: forming a well (11), having a first type of conductivity, within a wafer (10) of semiconductor material; defining active regions (12) within the well (11) extending in a first direction (y); forming memory cells (3) within the active regions (12), each memory cell (3) having a source region (15) with a second type of conductivity, opposite to the first type of conductivity; and forming lines of electrical contact (20), which electrically contact source regions (15) aligned in a second direction (x). In the step of forming lines of electrical contact (20), the step of forming an electrical contact between the source regions (15) and portions (37) of the well (11) adjacent thereto in the second direction (x).

Fig.4g

**Fig.5d**

**Description**

The present invention relates to a process for manufacturing a memory with local electrical contact between the source line and the well. In the following, explicit reference will be made to a floating-gate non-volatile memory, in particular an EEPROM flash memory, without this implying any loss of generality.

As is known, EEPROM (electrically erasable programmable read-only memories) flash memories are currently used in a wide number of electronic apparatuses, such as, for example, digital cameras, cellphones, or PDAs, for nonvolatile storage of data. In particular, EEPROM flash memories have the advantage of combining a high programming speed with a high storage density.

According to the organization of the memory cells, EEPROM flash memories are divided into NOR-type memories and NAND-type memories. As is known, NOR-type memories operate at higher speeds, whereas NAND-type memories have lower speeds but a higher data-storage density.

In synthesis, EEPROM flash memories comprise an array of memory cells organized in rows and columns and divided into sectors. The array of memory cells is formed in a wafer of semiconductor material comprising a substrate housing a plurality of wells. Each well is separated from the substrate by a buried region obtained by means of a deep implantation. Memory cells belonging to adjacent columns are electrically separated by insulation structures (for example, shallow-trench-insulation structures, or STI structures). Each memory cell is made of a floating-gate transistor and comprises: a gate region made above the well and formed by the superposition of a floating gate and a control gate separated from one another by a dielectric layer; and a source region and a drain region diffused within the well in a self-aligned way with respect to the gate region. EEPROM flash memories are electrically programmed via injection of electrons at a high energy (CHE - channel hot-electron injection), said electrons being stored in the floating gate, and are electrically erased via Fowler-Nordheim (FN) tunnelling effect.

Currently, biasing of the wells occurs through electrical contact areas at the border of each sector into which the memory array is divided. The presence of said electrical contact areas however entails a reduction in the efficiency and uniformity of area occupation of the memory array. In particular, the electrical contact areas account for 2% of the total size of the memory array.

Furthermore, during the programming operations of the memory cells, the current circulating in the well induces a voltage drop, the value of which varies with the distance of the memory cells from the electrical contact area at the border of the sector to which they belong. This consequently causes a body effect that varies as a function of the position of the memory cells within the corresponding sector, and a consequent increase in the width of the programmed threshold voltages distributions, this being particularly harmful in multilevel applications.

It is further known that the source regions of memory cells belonging to two adjacent rows of the memory array merge into a single continuous diffused line, referred to as source line. In particular, the source line is currently obtained via a socalled self-aligned-source (SAS) process, which envisages first the removal of the insulation structures separating the source regions of adjacent memory cells from one another, and then an ion implantation for electrically connecting to one another the various source regions belonging to one row and thus forming the continuous source line. Biasing of the source lines is obtained via metal lines at a reference voltage, which electrically contact the source lines every n memory cells (generally every 16 or 32 cells) so as to reduce the diffusion resistance.

In particular, assuming that the maximum value of the programming current $I_p$ circulating in the well during programming of the memory cells is known, the maximum number n of memory cells between two consecutive electrical contacts to a source line can be determined on the basis of the maximum value of the voltage drop $\Delta V$ on the diffused line (which is the voltage drop on the memory cell that is equidistant from two consecutive contacts), by applying the formula:

$$ n = \frac{4 \cdot \Delta V}{R_c \cdot I_p} $$

where $R_c$ is the resistance value of the source line for memory cell. With typical numeric values (namely, a value of approximately 500 $\Omega$/cell for $R_c$, a value of approximately 50 $\mu$A for Ip, and a value of approximately 200 mV for the voltage drop), it is possible to calculate the number n of memory cells between two successive contacts as being 32.

In particular, the electrical contacts on the source lines currently account for 12% of the total size of the memory array and hence constitute a constraint on the size reduction of the memory array.

The aim of the present invention is to provide a process for manufacturing a memory which will enable the aforesaid problems to be solved, and in particular will enable a higher efficiency to be achieved in terms of area occupation and uniformity in the arrangement of the electrical contacts for biasing the source lines and the wells, in order to satisfy the requirements of EEPROM flash memories with increasingly higher data-storage densities.

According to the present invention, a process for manufacturing a memory and the corresponding memory, as defined in Claims 1 and 10, respectively, are consequently provided.

For a better understanding of the present invention, a preferred embodiment thereof is now described, purely by way of non-limiting example and with reference to the attached drawings, wherein:

- Figure 1 shows a simplified block diagram of a memory device;
- Figure 2 shows a circuit diagram of a portion of a memory array of the memory device of Figure 1;
- Figure 3 shows a simplified top plan view of the memory array of Figure 2;
- Figures 4a-4g show cross sections through a wafer made of semiconductor material corresponding to successive steps of the process for manufacturing the memory array of Figure 3, taken along the line IV-IV; and
- Figures 5a-5d show cross sections through a wafer made of semiconductor material corresponding to successive steps of the process for manufacturing the memory array of Figure 3, taken along the line V-V.

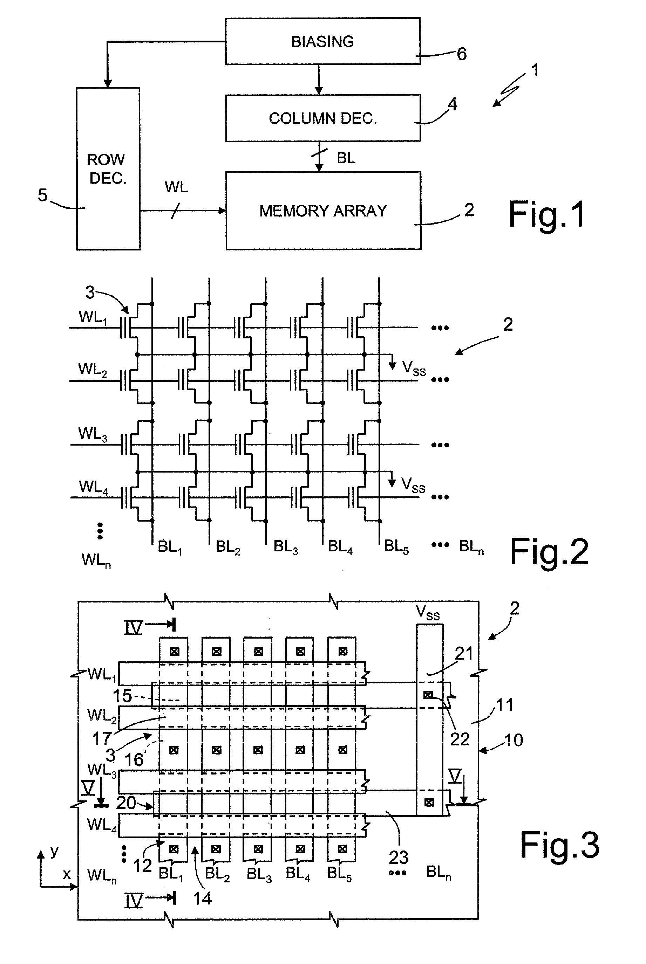

With reference to Figures 1-3, a memory device 1 of a NOR EEPROM flash type comprises a memory array 2 formed by a plurality of floating-gate memory cells 3, arranged in rows and columns. The memory cells 3 each have their control-gate terminal connected to a respective wordline $WL_1$-$WL_n$, their drain terminal connected to a respective bitline $BL_1$-$BL_n$, and their source terminal connected to a reference voltage $V_{ss}$. Memory cells 3 belonging to the same column are connected so as to share in pairs one and the same source terminal or one and the same drain terminal.

The bitlines BL extend in the direction of the columns of the memory array 2 (designated by y in Figure 3), whilst the wordlines WL extend in the direction of the rows of the memory array 2 (designated by x in Figure 3). The memory device 1 further comprises: a column decoder 4 connected to the bitlines BL; a row decoder 5 connected to the wordlines WL; and a biasing stage 6 connected to the column decoder 4 and row decoder 5.

In a per se known manner, the column decoder 4 and row decoder 5 enable selection in reading or in modifying (programming or erasure) of one or more memory cells 3 belonging to the memory array 2, on the basis of addresses received from the outside or from other components (not shown).

In detail, (with reference to Figure 3) the memory array 2 is formed in a wafer 10 of semiconductor material, for example silicon, in particular within wells 11 corresponding to surface portions of the wafer 10. In each well 11 a plurality of active regions 12, having a stripe-like conformation and extending parallel to one another in the y direction, and a plurality of insulation regions 14, set between consecutive active regions 12, are formed. The memory cells 3 are formed within the active regions 12. Memory cells 3 of a same stripe form the columns of the memory array 2, and the insulation regions 14 guarantee electrical insulation between memory cells 3 belonging to different columns.

Each memory cell 3 is constituted by a source region 15, a drain region 16, and a gate region 17, said gate region comprising a control gate and a floating gate, which are stacked on top of one another and are electrically insulated by means of an intermediate dielectric layer. The memory cells 3 are formed within the active regions 12, in such a way that two adjacent memory cells 3 share one and the same source region 15 or one and the same drain region 16.

The wordlines WL, which are made for example of polysilicon, extend in the x direction over the wafer 10 and form the control gate of the gate regions 17 of the various memory cells 3 belonging to one and the same row. The bitlines BL, which are typically made of metal, also extend over the wafer 10 (separated from the wordlines WL via a dielectric layer, not shown) and electrically contact the drain regions 16 of the memory cells 3 arranged along one and the same column. Furthermore, source lines 20 extend in the x direction (parallel to the wordlines WL) and electrically contact the source regions 15 of the memory cells 3 belonging to one and the same row. The source lines 20 are electrically contacted by metallization lines 21 every n memory cells 3 via source contacts 22. There is just one source line 20 every two wordlines WL, since each source region 15 is shared by two adjacent memory cells 3 along one and the same column.

As will be explained in detail hereinafter, according to one aspect of the present invention, the source lines 20 comprise silicide lines 23, which extend above a well 11 in the x direction. In particular, each silicide line 23 contacts directly both the source regions 15 aligned in the x direction and the portions of the well 11 set between said source regions 15. Basically, the source lines 20 are not constituted by uniformly doped diffused regions, possibly silicided, as in the case of EEPROM flash memories formed with a traditional SAS process, but rather by an alternation of diode junctions between the source regions 15, having a first type of conductivity, and portions of the well 11 adjacent thereto in the x direction, having a second type of conductivity; said junctions being short-circuited by the silicide line 23.

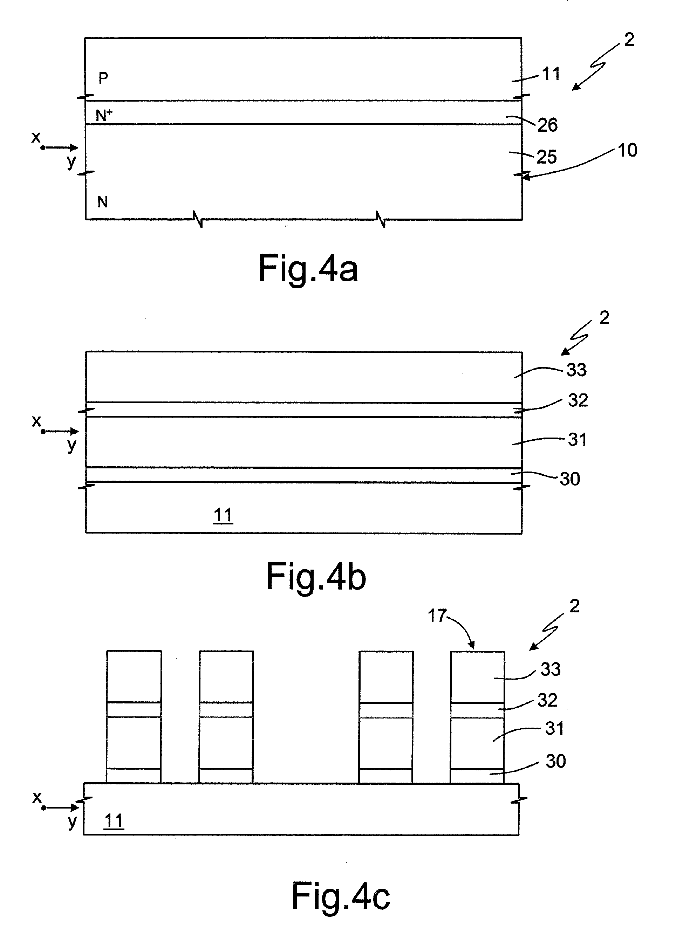

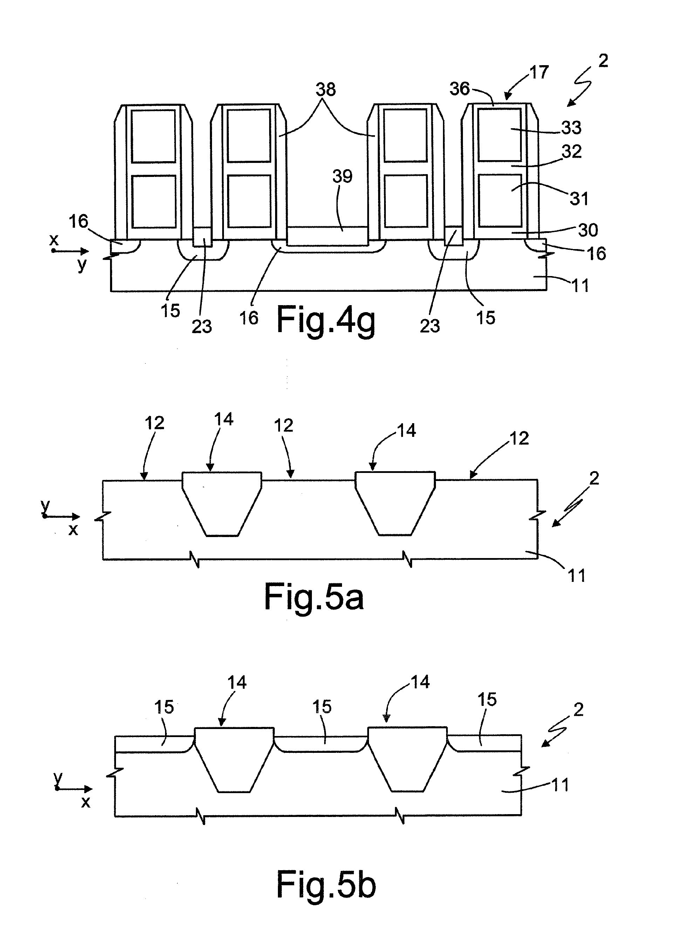

The main steps of the process for manufacturing the memory array 2 will now be described with reference to cross sections of the wafer 10 taken along the line IV-IV (y direction - Figures 4a-4g) and along the line V-V (x direction - Figures 5a-5d) .

Figure 4a shows the wafer 10 made of semiconductor material, for example monocrystalline silicon, comprising a substrate 25, for example of an N type.

Initially, a buried implanted region 26, for example of an $N^+$ type, and a well 11, for example of a P type (in the subsequent figures, for reasons of simplicity of illustration, only the well 11 will be shown) are formed inside the wafer 10. Next (see in particular Figure 5a), insulation regions 14 are defined in the well 11, which are here trenches of a preset depth filled with insulating material, typically silicon oxide, formed with shallow-trench-insulation (STI) techniques. Alternatively, the insulation regions 14 can be made with local oxidation of silicon (LOCOS) techniques. In a per se known manner, the insulation regions 14 delimit active regions 12 having a stripe-like conformation in the y direction (Figure 3).

Then (Figure 4b), on the surface of the wafer 10 the stacked layers which form the gate regions 17 are deposited and defined, namely, in succession: a thin tunnel oxide layer 30; a first polysilicon layer 31, forming the floating gate of each memory cell 3; an "interpoly"-oxide layer 32; and a second polysilicon layer 33, forming the control gate of each memory cell 3, and the wordlines WL.

At the end of the process, the structure of Figure 4c is obtained, said figure showing by way of example four gate regions 17. In particular, in a NOR-type memory array, the distance between two adjacent gate regions 17 in the y direction is minimum at the areas wherein the source regions 15 will be made.

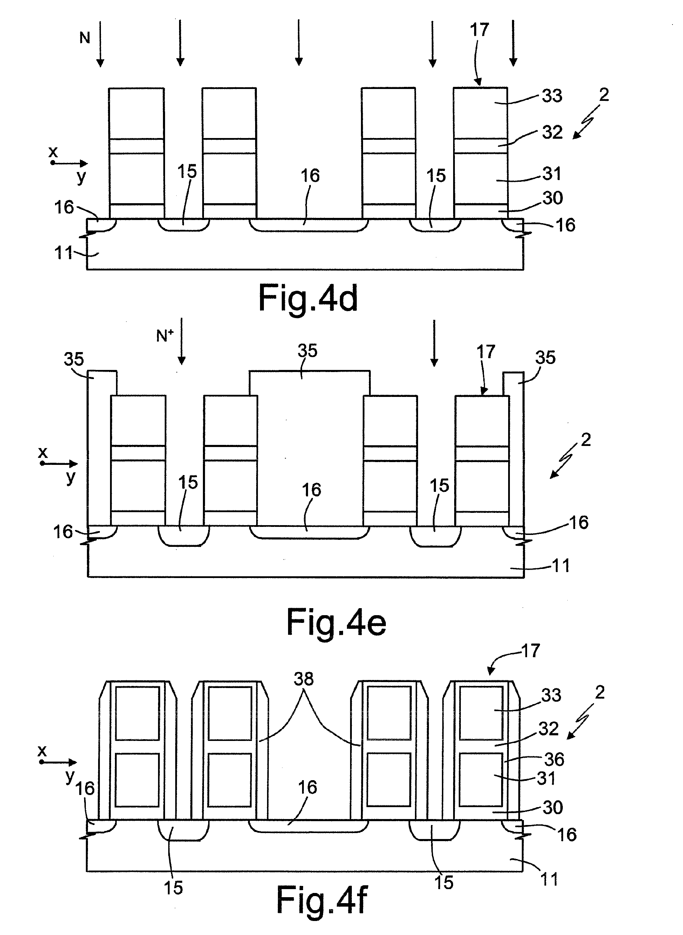

Then (Figure 4d), surface self-aligned implantations of an N type are carried out in order to form the source regions 15 and the drain regions 16 of the memory cells 3.

Next (Figures 4e and 5b), a mask 35 is formed, covering the drain regions 16 and the portions of the well 11 set between the drain regions 16, and an $N^+$ ion implantation is performed. Due to the mask 35 in the y direction (Figure 4e), and to the insulation regions 14 in the x direction (Figure 5b), the ion implantation is limited to the source regions 15 alone, which hence become deeper than the drain regions 16.

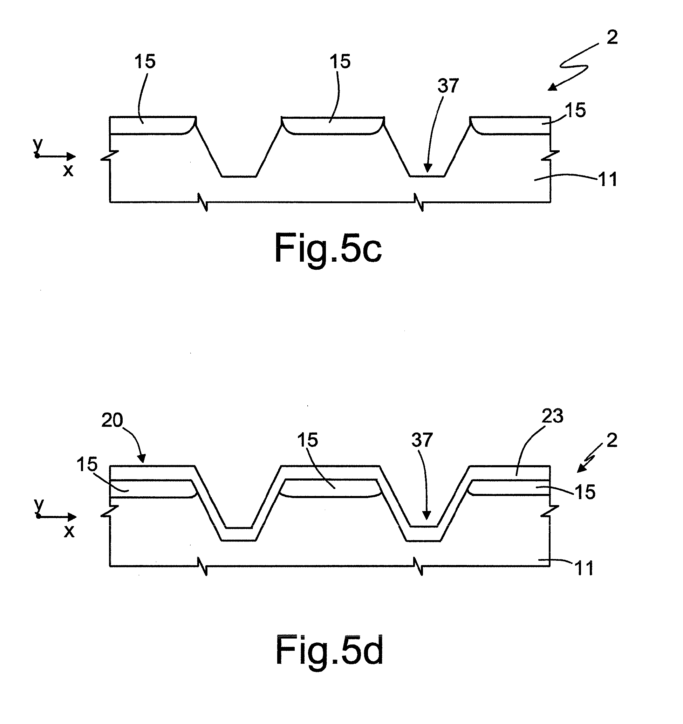

Then (Figure 5c), using the same mask 35, an etching is performed for removing the portions of the insulation regions 14 left uncovered by the mask 35, i.e., the portions set between the source regions 15 aligned in the x direction. At the end of the etching step, portions of the well 11, underneath the removed insulation regions 14, consequently remain exposed (said portions being referred to hereinafter as exposed portions 37).

Since the ion implantation is performed prior to etching of the insulation regions, the implanted ions do not reach the well 11, in particular the exposed portions 37, in so far as they are still covered by the insulation regions 14, which thus function as a mask for the implantation.

Next (Figure 4f), the memory cells 3 are sealed by means of a re-oxidation of the gate regions 17 and a possible deposition of a further thin dielectric layer 36. Furthermore, in a per se known manner not described in detail, spacers 38 made of silicon oxide or silicon nitride are formed along the walls of the gate regions 17. In particular, the size of the spacers 38 is such that they do not cover completely the source regions 15. In synthesis, formation of the spacers 38 envisages deposition of a dielectric layer (not shown) of silicon oxide or silicon nitride above the surface of the wafer 10, and then etching of the dielectric layer. A remaining portion of the dielectric layer at the end of the etching step forms the spacers 38.

Next, above the source regions 15 and the exposed portions 37, silicide lines 23 are formed, which extend with continuity in the x direction. For said purpose, silicidation of all the exposed silicon regions is performed. The process of silicidation initially envisages deposition of a conductive layer of a metal, such as for example titanium, cobalt or nickel, above the wafer 10. Then, the wafer 10 is heated, and the metal reacts with the underlying silicon forming regions of titanium silicide, cobalt silicide, or nickel silicide, whilst it does not bind to the silicon oxide of the insulation structures 14. The metal that has not reacted is then removed, whilst the silicide regions remain intact. In practice, only the exposed silicon regions are silicided during the step of silicidation.

In this way, as shown in Figures 4g and 5d, both the silicide lines 23 and silicide regions 39 above the drain regions 16 are formed. In particular, the silicide lines 23 locally shunt (i.e. at the individual memory cells 3) the source regions 15 and the exposed portions 37 of the well 11, so as to form the source lines 20.

The process for manufacturing the memory array 2 proceeds then in a known way (not illustrated in the figures), with the deposition of the premetal layer (or layers), and the formation of the electrical contacts and of the subsequent interconnections, in particular with the bitlines BL and wordlines WL.

The advantages of the manufacturing process and of the corresponding memory provided according to the present invention are clear from the foregoing description.

It is in any case emphasized that the formation of local contacts between the source regions of the memory cells and the well allows to avoid dedicated electrical contacts at the border of each sector for biasing the well. In fact, in order to bias the well, the same contacts used for biasing the source lines can be used. It is therefore possible to obtain a considerable saving in terms of area occupied by the memory array and an increase in the uniformity of the occupation of the area.

Furthermore, the consequent increase in the number of electrical contacts to the well as compared to the case of a single contact at the border of each sector reduces the problem of the variable body effect discussed in relation to the prior art.

In particular, the biasing of the well and of the source regions usually coincide for every operating condition of the memory device. Consequently, the functionalities of the memory device are not in any way limited by shunting the well and the source regions of the memory cells.

Furthermore, as is known, the resistivity of the silicided lines is much lower than that of simply implanted lines, generally approximately by one order of magnitude. Consequently, given the same resistance of the source lines, and the same maximum admissible voltage drop, the number of electrical contacts to the source lines is reduced by 1/10, with a further significant reduction in the overall dimensions of the memory array.

Furthermore, the manufacturing process according to the present invention is completely compatible with commonly used processes, since it does not require any additional process steps.

Finally, it is clear that modifications and variations can be made to the manufacturing process and the memory described herein, without thereby departing from the scope of the present invention, as defined in the appended claims.

In particular, the present invention can be applied to other types of memory, for example EEPROM memories or NAND-type memories, and to single-level or multilevel memories.

Furthermore, the spacer formation and the silicidation can be carried out in a way that is different from what is described herein, and that for silicidation a different metal material can be used. In particular, should the manufacturing process of the memory device envisage deposition of a layer of appropriate material, having the necessary compatibility characteristics for etching of the spacers (for example, silicon nitride, in the case of silicon-oxide spacers), the spacers can be made using said layer.

In addition, the spacers can be made with any material that does not react with the metal layer used during the silicidation step.

**Claims**

**1.** A process for manufacturing a memory (2) having a plurality of memory cells (3), comprising:

- forming a well (11) having a first type of conductivity within a wafer (10) of semiconductor material;
- defining active regions (12) within said well (11) extending in a first direction (y);
- forming a plurality of memory cells (3) within said active regions (12), each of said memory cells (3) comprising a source region (15) having a second type of conductivity, opposite to said first type of conductivity; and
- forming lines of electrical contact (20) electrically contacting source regions (15) aligned in a second direction (x);

**characterized in that** forming lines of electrical contact (20) comprises forming an electrical contact between said source regions (15) and portions (37) of said well (11) adjacent thereto in said second direction (x).

**2.** The process according to Claim 1, wherein forming lines of electrical contact (20) comprises forming continuous metal lines (23) above, and in direct electrical contact with, said source regions (15) and said portions (37), said metal lines (23) extending in said second direction (x).

**3.** The process according to Claim 2, wherein forming metal lines comprises forming silicide lines (23).

**4.** The process according to Claim 3, wherein forming silicide lines (23) comprises: depositing a layer of a metal chosen in the group comprising titanium, cobalt, and nickel above said well (11); causing a reaction between said metal layer and the underlying semiconductor material; and removing portions of said metal layer that has not reacted.

**5.** The process according to Claim 3 or Claim 4, wherein said memory cells (3) further comprise drain regions (16), and forming silicide lines further comprises forming silicide regions (39) above said drain regions (16).

**6.** The process according to any one of Claims 2-5, wherein defining active regions (12) comprises forming insulation regions (14) made of dielectric material extending in said first direction (y); and forming lines of electrical contact (20) comprises, prior to forming metal lines (23), removing portions of said insulation regions (14) between said source regions (15) aligned in said second direction (x), so as to have exposed portions (37) of said well (11).

**7.** The process according to Claim 6, wherein removing comprises forming a mask (35) above said wafer (10), said mask not covering said portions of said insulation regions (14) and said source regions (15).

**8.** The process according to Claim 7, wherein forming lines of electrical contact (20) comprises, prior to removal, executing an ion implantation of said well (11) with said second type of conductivity, through said mask (35).

**9.** The process according to any one of the preceding claims, wherein forming a plurality of memory cells (3) comprises forming gate regions (17) including a floating gate region (31) and a control-gate region (33), which are insulated from one another.

**10.** A memory (2) comprising a body (10) of semiconductor material housing at least one well (11), having a first type of conductivity and housing in turn a plurality of memory cells (3) aligned in rows (x) and columns (y); each memory cell (3) comprising a source region (15) having a second type of conductivity, opposite to said first type of conductivity, and being formed within said well (11); said memory further comprising lines of electrical contact (20), each in electrical contact with source regions (15) aligned along a respective row (x);
**characterized in that** said lines of electrical contact (20) further provide an electrical contact between said source regions (15) and portions (37) of said well (11) adjacent thereto along said rows (x).

11. The memory according to Claim 10, wherein said lines of electrical contact (20) comprise metal lines (23) extending above, and in direct electrical contact with, said source regions (15) and said portions (37), said metal lines (23) extending along said rows (x).

12. The memory according to Claim 11, wherein said metal lines (23) are made of a silicide of a metal chosen in the group comprising titanium, cobalt, and nickel.

13. The memory according to any one of Claims 10-12, further comprising insulation regions (14) made of dielectric material extending in the direction of said columns (y), between memory cells (3) that are adjacent in the direction of said rows (x), with the exception of said portions (37).

14. The memory according to any one of Claims 10-13, wherein said memory cells (3) are of the floating-gate type.

15. The memory according to any one of Claims 10-14, further comprising biasing lines (21), which are electrically connected to said lines of electrical contact (20) and bias said source regions (15) and said well (11) simultaneously.

16. A memory device (1), comprising a memory (2) according to any one of Claims 10-15.

Fig.1

Fig.2

Fig.3

**Fig.4a**

**Fig.4b**

**Fig.4c**

N

17

33

2

32

x

y

31

30

15

16

15

16

16

16

11

# Fig.4d

35

N⁺

35

17

35

x

y

2

15

16

15

16

16

16

11

# Fig.4e

17

38

33

2

32

36

31

30

x

y

16

16

16

16

15

15

11

# Fig.4f

**Fig.4g**

**Fig.5a**

**Fig.5b**

Fig.5c

Fig.5d

**European Patent Office**

## EUROPEAN SEARCH REPORT

Application Number

EP 05 42 5034

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/206447 A1 (TUAN HSING TI ET AL) 6 November 2003 (2003-11-06) * paragraphs [0151] - [0233]; figures 9-41 * | 1-16 | H01L21/768 H01L21/8247 H01L27/115 |
| X | US 2003/011023 A1 (HURLEY KELLY T) 16 January 2003 (2003-01-16) * paragraphs [0005] - [0030]; figures 1-10 * | 1-7,9-16 | |
| X | US 2003/027390 A1 (WOLSTENHOLME GRAHAM) 6 February 2003 (2003-02-06) * paragraphs [0024] - [0033]; figures 1-7 * | 1-7,9-16 | |
| X | US 6 207 515 B1 (HSIEH CHIA-TA ET AL) 27 March 2001 (2001-03-27) * column 2, line 7 - line 16 * * column 3, line 26 - column 6, line 13; figures 2,3 * | 1,9,10, 13-16 | |
| X | US 2003/151080 A1 (HURLEY KELLY T ET AL) 14 August 2003 (2003-08-14) * paragraphs [0035] - [0058]; figures 1-21 * | 1,9,10, 13-16 | TECHNICAL FIELDS SEARCHED (Int.Cl.7) H01L |
| X | US 2001/024857 A1 (PARAT KRISHNA ET AL) 27 September 2001 (2001-09-27) * paragraphs [0043], [0044], [0066], [0074]; figure 1 * | 1,9,10, 13-16 | |

The present search report has been drawn up for all claims

| Place of search | Date of completion of the search | Examiner |
|---|---|---|
| Munich | 16 June 2005 | Neumann, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................................
& : member of the same patent family, corresponding
    document

EPO FORM 1503 03.82 (P04C01)

**EP 1 686 620 A1**

**ANNEX TO THE EUROPEAN SEARCH REPORT
ON EUROPEAN PATENT APPLICATION NO.**

EP 05 42 5034

This annex lists the patent family members relating to the patent documents cited in the above-mentioned European search report.
The members are as contained in the European Patent Office EDP file on
The European Patent Office is in no way liable for these particulars which are merely given for the purpose of information.

16-06-2005

| Patent document cited in search report | | Publication date | Patent family member(s) | | Publication date |
|---|---|---|---|---|---|
| US 2003206447 | A1 | 06-11-2003 | US | 2002038897 A1 | 04-04-2002 |
| | | | US | 6355524 B1 | 12-03-2002 |
| | | | TW | 508814 B | 01-11-2002 |
| | | | US | 2002151141 A1 | 17-10-2002 |
| | | | US | 2002022314 A1 | 21-02-2002 |
| | | | US | 2002042180 A1 | 11-04-2002 |
| US 2003011023 | A1 | 16-01-2003 | NONE | | |
| US 2003027390 | A1 | 06-02-2003 | US | 2002039821 A1 | 04-04-2002 |
| | | | US | 2003064563 A1 | 03-04-2003 |
| US 6207515 | B1 | 27-03-2001 | US | 2001017387 A1 | 30-08-2001 |
| US 2003151080 | A1 | 14-08-2003 | US | 2003034511 A1 | 20-02-2003 |
| | | | US | 6624022 B1 | 23-09-2003 |
| US 2001024857 | A1 | 27-09-2001 | US | 6265292 B1 | 24-07-2001 |

EPO FORM P0459

For more details about this annex : see Official Journal of the European Patent Office, No. 12/82